Europäisches Patentamt

European Patent Office

Office européen des brevets

(11) Numéro de publication: **0 101 773**
**B1**

(12) **FASCICULE DE BREVET EUROPEEN**

(45) Date de publication du fascicule du brevet: **24.09.86**

(51) Int. Cl.⁴: **H 02 P 5/40,** G 01 R 31/34

(21) Numéro de dépôt: **82401608.3**

(22) Date de dépôt: **31.08.82**

(54) **Procédé et dispositif de mesure du glissement d'un moteur.**

(43) Date de publication de la demande:
**07.03.84 Bulletin 84/10**

(45) Mention de la délivrance du brevet:
**24.09.86 Bulletin 86/39**

(84) Etats contractants désignés:
**AT BE CH DE FR GB IT LI LU NL SE**

(56) Documents cités:
**DE-A-2 203 487**

**IEEE TRANSACTIONS ON INDUSTRY APPLICATIONS, vol. IA11, no. 5, September/October 1975 A. ABBONDANTI et al. "Variable speed induction motor drives use electronic slip calculator based on motor voltages and currents", pages 483-488**

(73) Titulaire: **LA TELEMECANIQUE ELECTRIQUE**
**33 bis, avenue du Maréchal Joffre**
**F-92000 Nanterre (FR)**

(72) Inventeur: **Notelet, Francis**
**La Falaise Route Départementale 60**
**Achicourt F-61217 Beaurains (FR)**
Inventeur: **Pillais, Jacky**
**31, Square Saint Exupéry**
**F-92500 Rueil Malmaison (FR)**

(74) Mandataire: **Marquer, Francis**
**CABINET MOUTARD 35, avenue Victor Hugo**
**Résidence Champfleury**
**F-78180 Voisins-le-Bretonneux (FR)**

Courier Press, Leamington Spa, England.

# 0 101 773

## Description

La présente invention concerne un perfectionnement de la demande de brevet français déposée par la demanderesse, le 6 Octobre 1981 sous le numéro 81 19 124, intitulée "Procédé et dispositif de mesure du glissement d'un moteur" et publiée le 08.04.83 sous le numéro FR—A—2514146. L'invention précédente résultait d'une approximation valable tant que la fréquence était suffisante dans le but de simplifier la méthode et les mesures et d'aboutir à une solution réalisable techniquement. Toutefois cette méthode ne présente pas une précision satisfaisante aux très basses fréquences compte-tenu des approximations faites. Il en résultait que la méthode était mal adaptée aux moteurs utilisés pour des entraînements où la fréquence peut descendre à des valeurs très faibles, ainsi qu'aux moteurs dont la résistance et l'inductance rotorique sont fonction de la pulsation du rotor. Enfin la méthode précédente, une fois la phase d'acquisition des mesures effectuée, nécessitait une phase de calcul assez longue par une formule complexe.

Ces inconvénients se retrouvent également dans le dispositif décrit dans l'article de A. Abbondanti et al. paru dans la revue IEEE Transactions on Industry Applications, volume IA 11, No 5, septembre/octobre 1975, pages 483 à 488 qui décrit également un dispositif pour la détermination du glissement d'un moteur asynchrone alimenté par une source polyphasée à pulsation variable (convertisseur) sans utilisation d'un détecteur tachymétrique, à partir de mesures de tension et de courant effectuées aux bornes statoriques du moteur.

Un premier but du présent perfectionnement est de définir un procédé et un dispositif de mesure et de détermination du glissement d'un moteur donnant des résultats d'une plus grande précision par une meilleure reconnaissance du moteur et qui soit utilisable pour des moteurs asynchrones à bagues et à cage.

Un deuxième but vise à fournir un procédé et un dispositif plus simples de détermination du glissement d'un moteur. Un dernier but est la création d'un procédé et d'un dispositif qui puisse être utilisé pour la commande d'un moteur alimenté par un gradateur ou un convertisseur.

Pour parvenir à ces résultats, l'invention concerne un procédé de détermination du glissement d'un moteur asynchrone, alimenté par une source polyphasée à pulsation variable sans utilisation d'un détecteur tachymétrique, à l'aide de mesures d'impédances effectuées à ses bornes statoriques, caractérisé en ce qu'il comporte la détermination préliminaire, à partir de mesures effectuées sur le moteur à l'arrêt de la résistance statorique $r_1$ et sur le moteur à vide de la réactance $X_o$ pour les diverses pulsations $\omega$ de la source alimentant le moteur; la détermination préliminaire de la résistance $R_c$ et de la réactance $X_c$ du moteur, rotor bloqué, pour les diverses pulsations $\omega$ de la source alimentant le moteur; la mesure de la résistance $R$ et de la réactance $X$ du moteur en fonctionnement alimenté à la pulsation $\omega$ et le calcul du glissement à partir des résultats des déterminations préliminaires et de la mesure de R et X, en utilisant une formule de la forme:

$$g = a\,(\omega)\,\frac{X_o\,(\omega) - X}{R - r_1}$$

$$\text{avec } a\,(\omega) = \frac{R_c\,(\omega) - r_1}{X_o\,(\omega) - X_c\,(\omega)}$$

L'invention propose également un procédé de détermination du glissement d'un moteur asynchrone alimenté par une source polyphasée à pulsation variable sans utilisation d'un détecteur tachymétrique, à l'aide de mesures d'impédances effectuées à ses bornes statoriques, caractérisé en ce qu'il comporte:

la détermination préliminaire de la résistance statorique $r_1$ à partir de mesures effectuées sur le moteur à l'arrêt;

la détermination préliminaire, sur le moteur à vide de la réactance $X_o$ pour diverses pulsations $\omega$ de la source alimentant le moteur;

la détermination préliminaire de la résistance $R_c$ et de la résistance $X_c$ du moteur, rotor bloqué, pour diverses pulsations $\omega$ de la source alimentant le moteur;

le rangement, dans un bloc de mémoire, des valeurs mesurées de la résistance $r_1$ et de la réactance $X_o$, à des adresses correspondant à la pulsation du courant;

la détermination et le rangement, dans un bloc de mémoire, de coefficients $a\,(\omega)$, à des adresses correspondant à la pulsation $\omega$ du courant, ces coefficients étant obtenus au moyen de la relation:

$$a\,(\omega) = \frac{R_c - r_1}{X_o - X_c} = \frac{R_c\,(\omega) - r_1}{X_o\,(\omega) - X_c\,(\omega)}$$

la mesure de la résistance R et de la réactance X du moteur en fonctionnement alimenté à la pulsation $\omega$;

la détermination d'une constante

$$K = \frac{R - r_1}{X_o - X}$$

la détermination dans la mémoire à quelle valeur de pulsation K correspond le terme K, tel que $K = a\,(\omega K)$; et

la détermination du glissement par le rapport

$$\frac{\omega K}{\omega} = g.$$

L'invention a en outre pour objet un dispositif pour la détermination du glissement d'un moteur asynchrone alimenté par une source polyphasée à pulsation variable sans utilisation d'un détecteur tachymétrique, à partir de mesures de tension et de courant effectuées aux bornes statoriques du moteur, caractérisé en ce qu'il comprend:

des premiers moyens permettant de mesurer la résistance statorique $r_1$ du moteur alimenté à l'arrêt par un courant continu, et de ranger dans une première mémoire le signal numérique représentant la valeur de $r_1$;

des seconds moyens pour déterminer la réactance $X_o$ du moteur chargé à vide et alimenté par un courant de pulsation $\omega$, et pour ranger dans une seconde mémoire une adresse correspondant à la pulsation $\omega$, le signal représentatif de la réactance $X_o$;

des troisièmes moyens pour déterminer les valeurs $R_c$ et $X_c$ représentatives de la résistance et de la réactance du moteur, rotor bloqué mécaniquement, alimenté par un signal de pulsation $\omega$, pour déterminer, pour chaque valeur de la pulsation $\omega$, un terme $a\,(\omega)$ ayant pour valeur

$$a\,(\omega) = \frac{R_c - r_1}{X_o - X_c},$$

et pour ranger dans une troisième mémoire la valeur $a\,(\omega)$ à l'adresse correspondant à la pulsation;

des quatrièmes moyens pour mesurer la résistance R et la réactance X du moteur alimenté avec un signal de pulsation $\omega$ et entraînant une charge, pour extraire desdites première seconde et troisième mémoires les valeurs $X_o$, $r_1$ et $a\,(\omega)$ correspondantes et pour calculer le glissement g au moyen d'une formule de la forme

$$g = a\,(\omega) \cdot \frac{X_o - X}{R - r_1}.$$

Par ailleurs, l'invention a également pour objet un dispositif pour la détermination du glissement d'un moteur asynchrone alimenté par une source polyphasée à pulsation variable sans utilisation d'un détecteur tachymétrique, à partir de mesures de tension et de courant effectuées aux bornes statoriques du moteur, caractérisé en ce qu'il comprend:

un circuit délivrant des signaux représentatifs de la tension instantanée et de la tension efficace de ladite source de tension;

un dispositif pour la mesure de la valeur instantanée et de la valeur efficace du courant délivré par ladite source;

un circuit permettant de délivrer, à partir desdites mesures de tension et de courant, des signaux numériques représentatifs de la résistance et de la réactance apparente du moteur, vu du stator;

un ensemble à microprocesseur recevant sur une entrée les susdits signaux numériques, cet ensemble comprenant des moyens pour la mémorisation de la valeur de la résistance statorique $r_1$ du moteur à l'arrêt alimenté en courant continu, des moyens pour la mémorisation, à des adresses correspondant à la pulsation $\omega$ de la valeur de la réactance apparente $X_o$ du moteur, lorsque celui-ci est à vide et est alimenté par un signal de pulsation $\omega$, et de la valeur de la résistance apparente $R_c$ et de la réactance apparente $X_c$ du moteur, rotor mécaniquement bloqué, et alimenté avec un signal de pulsation $\omega$, et des moyens pour calculer le glissement g à partir des valeurs mesurées de la résistance apparente R et de la réactance apparente X du moteur alimenté avec un signal de pulsation $\omega$ et entraînant une charge, et des valeurs $r_1$, $X_c$, $R_c$ précédemment mémorisées, à l'aide d'une formule de la forme:

$$g = \frac{R_c - r_1}{X_o - X_c} \cdot \frac{X_o - X}{R - r_1}$$

3

## 0 101 773

D'autres caractéristiques et avantages de la présente invention apparaîtront plus clairement à la lecture de la description faite en référence aux dessins annexés, dans lesquels:

la figure 1 est un dispositif de détermination du glissement;

la figure 2 est un mode de réalisation du circuit de mesure associé à la figure 1;

la figure 3 est un mode de réalisation d'un circuit de calcul du glissement pour un moteur alimenté par gradateur et;

la figure 4 est un mode de réalisation d'un circuit de calcul du glissement pour un moteur alimenté par convertisseur.

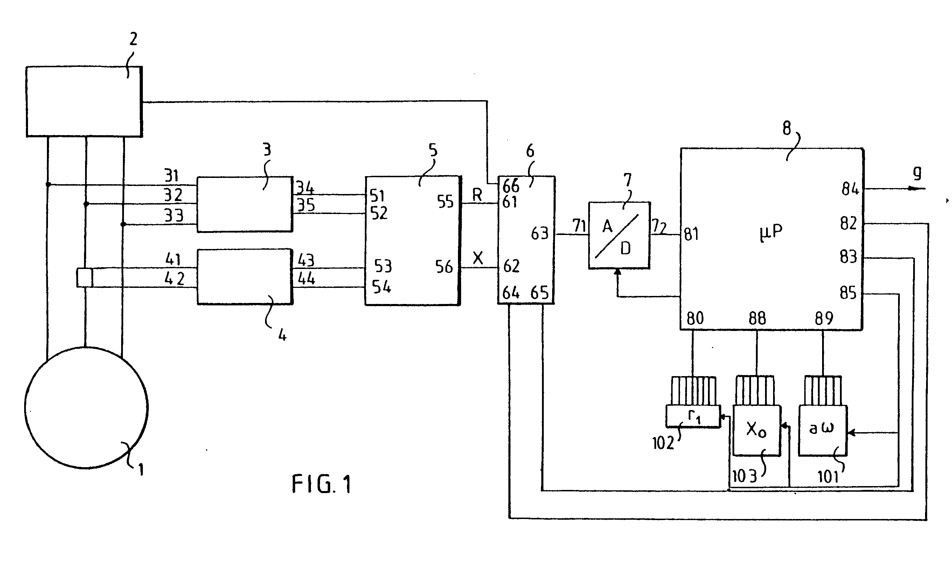

La figure 1 représente une vue schématique du dispositif, dans lequel 1 représente un moteur électrique asynchrone polyphasé alimenté par un dispositif 2 connu pouvant être un convertisseur ou, éventuellement, un gradateur. Le gradateur délivre une tension variable à une fréquence constante, tandis que le convertisseur délivre une tension et une fréquence variables.

La tension délivrée par le gradateur ou le convertisseur 2 est mesurée par un circuit 3 analogique dont chacune de ses entrées 31, 32, 33 sont branchées sur une phase et délivrant, sur la sortie 34, un signal représentant la tension instantanée u, tandis que, sur la sortie 35, on obtient un signal représentant la tension efficace. Le courant alimentant le moteur 1 est mesuré par des moyens connus et le signal représentant le courant est introduit sur les entrées 41, 42 d'un circuit analogique 4 délivrant, sur sa sortie 43, la valeur instantanée du courant et, sur sa sortie 44, la valeur efficace: les sorties 34, 35, 43, 44 sont branchées aux entrées 51, 52, 53, 54 d'un circuit analogique 5 délivrant sur sa sortie 55 un signal représentatif de la valeur de la résistance apparente du moteur vu du stator, tandis que sa sortie 56 délivre un signal représentatif de la réactance apparente du moteur vu du stator. Ces signaux sont envoyés aux entrées 61, 62 d'un multiplexeur 6 dont la sortie 63 est branchée à l'entrée 71 d'un convertisseur analogique-numérique 7; cette partie pourrait également être réalisée numériquement. La sortie 72 est reliée à une entrée 81 d'un ensemble micro-processeur 8. Le multiplexeur 6 est adressé en 64, 65 par les signaux délivrés aux sorties 82, 83 du micro-processeur. Les signaux issus respectivement de 80, 88, 89 sont pour chaque valeur de $\omega$ adressés à des mémoires vives 101, 102, 103. Le micro-processeur effectue l'adressage en fonction de la valeur de $\omega$ reçue en 81. Ces mémoires vives 101, 102, 103 servent à mettre en mémoire les signaux représentant les valeurs respectives de a $(\omega)$ pour 101; $R_x$, ou $R_0$ et $R_1$ pour 102 et $X_0$, $X_c$ pour 103, comme on l'expliquera par la suite. D'autre part, suivant le système, le micro-processeur, reçoit en 81 par l'intermediaire du convertisseur 7 un signal représentatif de la pulsation $\omega$, de l'organe 2 d'alimentation du moteur, le micro-processeur utilisant ses résultats sur la détermination du glissement g pour commander le moteur, mais une première solution consiste en ce que le micro-processeur 8 a seulement pour tâche de calculer le glissement sans commander d'autres organes.

Pour calculer le glissement, le micro-processeur utilise la formule suivante:

$$ g = \frac{R_c - r_1}{X_o - X_c} \cdot \frac{X_o - X}{R - r_1} $$

dans laquelle: $r_1$ représente la résistance statorique du moteur non alimenté;

$X_o$ représente la réactance apparente du moteur, vu du stator, lorsque celui-ci est à vide et alimenté par un signal de pulsation $\omega$;

$R_c$ et $X_c$ représentent respectivement la résistance apparente et la réactance apparente du moteur calé alimenté par un signal de pulsation $\omega$;

R et X représentent respectivement la résistance apparente et la réactance apparente du moteur en fonctionnement normal, alimenté par un signal de pulsation $\omega$.

Pour mettre en œuvre ce calcul on procède en deux phases; une phase de reconnaissance du moteur et une deuxième phase de fonctionnement normal, pendant laquelle on détermine le glissement.

Dans la première phase de reconnaissance, le moteur étant à l'arrêt, on mesure la résistance statorique $r_1$ du moteur alimenté en courant continu par l'organe 2; le micro-processeur, par adressage du multiplexeur 6 et de la mémoire 102, range dans la mémoire 102 le signal numérique représentant la valeur de $r_1$.

Ensuite, on alimente par un signal de pulsation $\omega$, le moteur chargé à vide et le micro-processeur, par adressage du multiplexeur 6 et de la mémoire 103 range dans la mémoire vive (RAM 103), à l'adresse correspondante à la pulsation $\omega$, le signal représentatif de la valeur $X_o$. On effectue un balayage de toutes les pulsations $\omega$ auxquelles le moteur devra fonctionner et on range en 103 les différentes valeurs.

Enfin le moteur étant calé (c'est-à-dire rotor bloqué), on alimente ce dernier avec un signal de pulsation $\omega$ et, pour chaque valeur de la pulsation, le micro-processeur, en commandant le multiplexeur 6, fait entrer dans deux registres internes, l'information numérique représentant les valeurs $R_c$ et $X_c$ représentatives de la résistance et de la réactance du moteur vu du stator. Puis, après être allé chercher dans la mémoire 103 la valeur $X_o$ correspondant à la pulsation $\omega$ et dans la mémoire 102 la valeur $r_1$, le micro-processeur 8 détermine par calcul un terme a $(\omega)$

4

$$- \quad a\,(\omega) = \frac{R_c - r_1}{X_o - X_c}$$

qu'il va ranger dans la mémoire 101 à l'adresse correspondant à la pulsation $\omega$.

Cette phase de reconnaissance étant achevée, on a donc, en mémoire 103, une série de $\eta$ valeurs de $X_o$ $(\omega)$; dans la mémoire 102, la valeur $r_1$ et dans la mémoire 101, les $\eta$ valeurs de $a\,(\omega)$, calculées aux différentes pulsations. On passe ensuite à la phase de détermination du glissement, dans laquelle le moteur est alimenté avec un signal de pulsation $\omega$ et ce moteur entraine une charge. On mesure en fonctionnement les valeurs X et R et le micro-processeur, par adressage du multiplexeur 6, fait entrer successivement dans ses registres internes, les valeurs R et X. Ensuite, le micro-processeur va extraire de la mémoire 103 la valeur $X_o\,(\omega)$; de la mémoire 102, la valeur $r_1$ et, de la mémoire 101, la valeur $a\,(\omega)$, pour calculer le glissement g au moyen de la formule

$$g = a\,(\omega) \cdot \frac{X_o - X}{R - r_1}$$

Une autre méthode pourrait consister, au cours de la deuxième phase, à calculer, pour une pulsation $\omega$ de fonctionnement donnée, le terme

$$\frac{R - r_1}{X_o - X} = K$$

et de regarder, dans la table constituée par les valeurs $a\,(\omega)$ enregistrées dans la mémoire 101, à quelle valeur de pulsation $\omega_K$ correspond cette valeur K telle que $K = a\,(\omega_K)$

Ensuite ayant déduit $\omega_K$ et connaissant $\omega$, on détermine le glissement par la formule

$$g = \frac{\omega_K}{\omega}$$

Cette dernière méthode est plus précise que la première, car l'erreur de détermination de $a\,(\omega)$ n'est pas multipliée par une constante comme dans la première méthode.

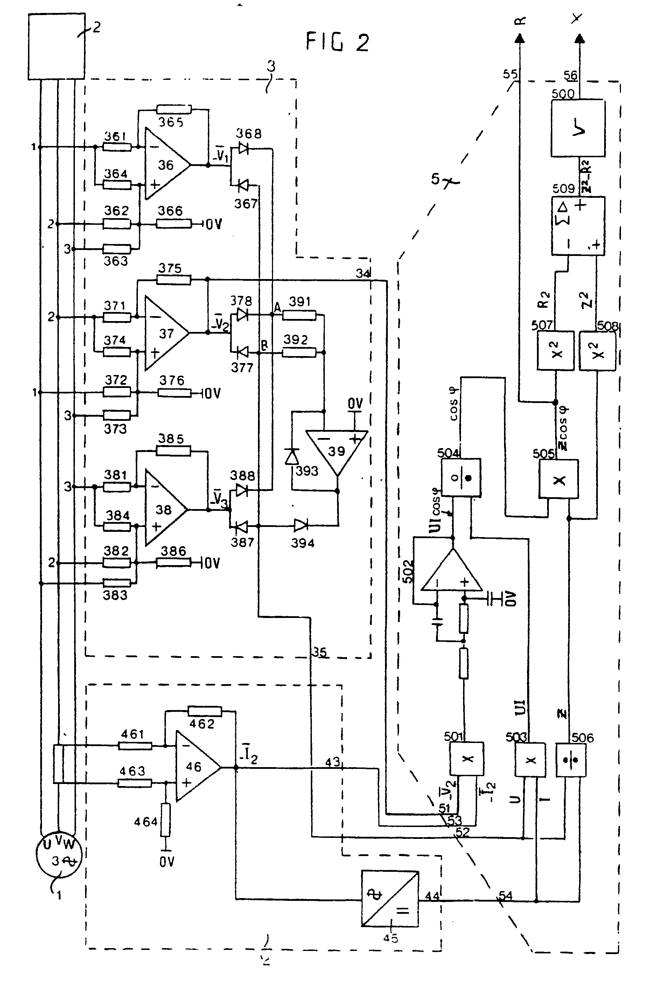

La figure 2 représente un mode de réalisation particulier des circuits 3, 4 et 5 de la figure 1, dans lequel le circuit 3 est constitué par une série de trois amplificateurs différentiels 36, 37 et 38, branchés: respectivement par les résistances 361 et 364, 372, 383 à la phase 1; respectivement par les resistances 362, 371 et 374, 382 à la phase 2; respectivement par les resistances 363, 373, 381 et 384 à la phase 3. La résistance 361 est reliée d'une part à l'entrée négative de l'amplificateur 36 et d'autre part au moyen d'une résistance 365 à la sortie de l'amplificateur. La résistance 364 est reliée d'une part à l'entrée positive de l'amplificateur 36 et d'autre part aux résistances 362, 363 et 366, l'autre extrémité de la résistance 366 étant reliée à la masse. La sortie de l'amplificateur 36 délivre un signal qui représente $-\overline{V_1}$, ($v_1$ étant la tension simple instantanée de la phase 1). Le branchement des amplificateurs 37 et 38 se déduit de celui de l'amplificateur 36 par permutation circulaire des résistances 371 à 376 et 381 à 386. La sortie de chaque amplificateur 36 à 38 est branchée, d'une part à l'anode de la diode respective 368, 378, 388 et, d'autre part, à la cathode de la diode respective 367, 377, 387, dont les cathodes, respectivement les anodes, sont branchées respectivement aux points communs A, B, de façon à constituer un pont de redressement. Les points A et B sont reliés à l'entrée négative de l'amplificateur 39 par les résistances respectives 391, 392. L'entrée positive de l'amplificateur 39 est reliée à la masse. La sortie de l'amplificateur 39 est reliée, d'une part, par un diode 394 montée dans le sens inverse, au point commun B et, d'autre part, à son entrée négative, par une diode 393 branchée par son anode à la sortie. Le point B constitue la sortie notée 35 de la figure 1, tandis que la sortie de l'amplificateur 37 constitue la sortie notée 34 de la figure 1.

Le circuit 4 est constitué par un capteur de courant relié à un amplificateur différentiel 46. L'entrée négative est reliée, d'une part au capteur par une résistance 461, d'autre part à la sortie de l'amplificateur 46 par une résistance 462. L'entrée positive de l'amplificateur 46 est reliée d'une part à la masse par une résistance 464 et d'autre part au capteur par une résistance 463. La sortie de l'amplificateur 46 constitue la sortie 43 du circuit 4 et est reliée à l'entrée d'un convertisseur alternatif-continu 45 dont la sortie constitue la sortie 44. Ce convertisseur pourra être réalisé par un pont de redressement à double alternance ou par un convertisseur intégré fournissant une tension continue proportionnelle à la valeur efficace vraie du signal.

Le circuit 5 est constitué par un multiplicateur 501 dont les entrées 51, 53 reçoivent les signaux des sorties 34 et 43 représentant respectivement la tension et le courant instantané. La sortie du circuit 501, exprimant la puissance instantanée, est branchée à un filtre de Butterworth 502, de façon à obtenir en sortie la puissance moyenne. Le signal sortant du filtre 502 est branché à la première entrée 504 d'un circuit diviseur dont la deuxième entrée reçoit un signal représentant la puissance apparente issue d'un circuit 503 recevant en entrée la tension et l'intensité efficace 35 et 44. La sortie de diviseur 504, qui représente cos $\varphi$,

**0 101 773**

est branchée à la première entrée d'un circuit multiplicateur 505, dont la deuxième entrée reçoit le signal représentant l'impédance Z, issu d'un circuit diviseur 506 recevant en entrée l'intensité et la tension efficace issues de 44 et 35.

Le signal en sortie de 505 représente $Z \cos \varphi$, c'est-à-dire la résistance R.

Les signaux issus de 505 et de 506 sont chacun introduits dans un circuit respectif, élévateur au carré 507, 508. La sortie de 507 représentant $R^2$ est branchée à l'entrée négative d'un circuit différenciateur 509, tandis que l'entrée positive de ce circuit 509 reçoit la sortie de 508 représentant $Z^2$. La sortie de 509, représentant $Z^2 - R^2$, est introduite dans le circuit 500 calculant la racine carrée et dont la sortie 56 représente la réactance X.

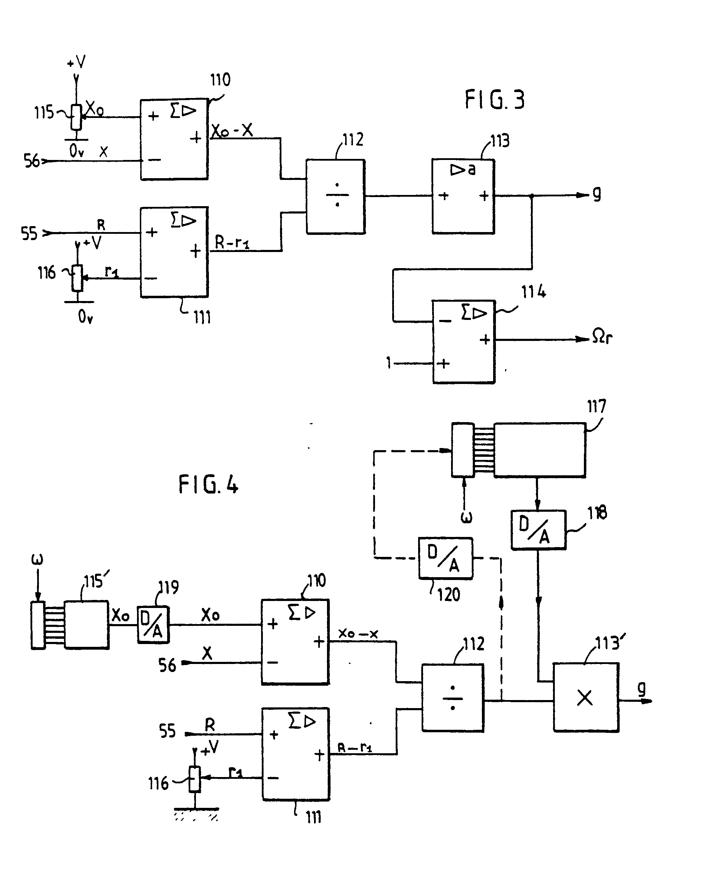

La figure 3 représente un mode de réalisation d'un circuit de calcul du glissement lorsque le moteur est alimenté par un gradateur et, par conséquent, travaille à fréquence fixe et tension variable. Dans ce type d'utilisation, on a intérêt à dissocier la phase de reconnaissance du moteur de la phase de détermination du glissement.

Comme l'on fonctionne à pulsation fixe, il suffit, dans la première phase, de mesurer, au moyen du circuit de la figure 2 par exemple, les valeurs

$$b = X_o ; \quad d = R_c$$

$$c = r_1 ; \quad e = X_c$$

obtenues pour la pulsation de fonctionement et de calculer

$$a = \frac{R_c - r_1}{X_o - X_c}$$

Le circuit de la figure 3 permet, à partir de a, b, c, de déterminer le glissement et la vitesse de rotation du moteur. L'entrée négative d'un amplificateur différentiel 110 reçoit le signal issu de la borne 56 du circuit (figure 2) représentant la réactance. L'entrée positive de l'amplificateur 110 est reliée au curseur d'un potentiomètre 115 branché, d'une part à la masse et, d'autre part, à un potentiel de +15 V. Le curseur du potentiomètre sera réglé de façon que le signal présent à l'entrée positive représente la valeur $X_o$.

Un deuxième amplificateur différentiel 111 reçoit sur son entrée positive le signal sortant en 55 du circuit 5 et représentant la résistance, tandis que l'entrée négative est branchée au curseur d'un potentiomètre 116 branché, d'une part à la masse et, d'autre part, à un potentiel de +15 V.

Le curseur du potentiomètre sera réglé de façon que le signal présent à l'entrée nègative représente la valeur $r_1$. Les sorties respectives des amplificateurs 110, 111 representent respectivement les valeurs $X_o - X$ et $R - r_1$ sont branchées aux entrées d'un diviseur 112 dont la sortie est reliée à un amplificateur 113 de gain

$$a = \frac{R_c - r_1}{X_o - X_c}$$

La sortie de cet amplificateur représente donc le glissement g. Le signal représentant le glissement pourra être relié à l'entrée négative d'un amplificateur différentiel 114, dont l'entrée positive est reliée à un potentiel représentant la valuer 1. En sortie de l'amplificateur 114, on obtient un signal représentant la vitesse angulaire du rotor $\Omega_r$.

La figure 4 représente un circuit de calcul qui pourrait être utilisé dans le cas d'une application à un moteur alimenté par un convertisseur.

Les éléments de la figure 4 identiques à ceux de la figure 3 gardent les mêmes références.

Le potentiomètre 115 est remplacé par une mémoire 115' adressée par la pulsation $\omega$ et dont le signal de sortie est fourni à l'amplificateur 110 après être passé dans un convertisseur analogique-numérique 119. L'amplificateur de gain 113 est remplacé par un circuit multiplicateur 113' dont la deuxième entrée est fournie par le signal de sortie d'une mémoire 117, après son passage dans un convertisseur numérique analogique 118. Cette mémoire 117' est également adressée par un signal représentant la pulsation $\omega$.

Le signal représentant la pulsation $\omega$ pourra être élaboré de façon connue en déterminant le nombre de coups d'une horloge séparant deux fronts de montée du signal.

Le contenu de la mémoire 117 pourra être rempli, dans la première phase, en utilisant la sortie du diviseur 112 que l'on branche, par l'intermédiaire d'un convertisseur analogique-numérique 120, à l'entrée de la mémoire 117, comme représenté en pointillé sur la figure 4.

Il est évident que la détermination de a ($\omega$) n'est pas indispensable et qu'elle n'est effectuée que dans le but de diminuer le nombre de mémoires à utiliser. Au lieu de calculer a ($\omega$), on pourrait appliquer la même méthode en utilisant plusieurs mémoires $X_o$, $X_c$, $R_c$ et $r_1$ et en ne calculant le glissement que pendant le fonctionnement.

6

## Revendications

1. Procédé de détermination du glissement d'un moteur asynchrone (1), alimenté par une source polyphasée à pulsation variable (2) sans utilisation d'un détecteur tachymétrique, à l'aide de mesures d'impédances effectuées à ses bornes statoriques, caractérisé en ce qu'il comporte la détermination préliminaire, à partir de mesures effectuées sur le moteur à l'arrêt de la résistance statorique $r_1$ et sur le moteur à vide de la réactance $X_o$ pour les diverses pulsations $\omega$ de la source alimentant le moteur; la détermination préliminaire de la résistance $R_c$ et de la réactance $X_c$ du moteur, rotor bloqué, pour les diverses pulsations $\omega$ de la source alimentant le moteur; la mesure de la résistance R et de la réactance X du moteur en fonctionnement alimenté à la pulsation $\omega$ et le calcul du glissement à partir des résultats des déterminations préliminaires et de la mesure de R et X, en utilisant une formule de la forme:

$$g = a\,(\omega)\frac{X_o\,(\omega) - X}{R - r_1}$$

$$\text{avec } a\,(\omega) = \frac{R_c\,(\omega) - r_1}{X_o\,(\omega) - X_c\,(\omega)}$$

2. Procédé de détermination du glissement d'un moteur asynchrone (1) alimenté par une source polyphasée à pulsation variable (2) sans utilisation d'un détecteur tachymétrique, à l'aide de mesures d'impédances effectuées à ses bornes statoriques, caractérise en ce qu'il comporte:

la détermination préliminaire de la résistance statorique $r_1$ à partir de mesures effectuées sur le moteur à l'arrêt;

la détermination préliminaire, sur le moteur à vide de la résistance $X_o$ pour diverses pulsations $\omega$ de la source alimentant le moteur;

la détermination préliminaire de la résistance $R_c$ et de la réactance $X_c$ du moteur, rotor bloqué, pour diverses pulsations $\omega$ de la source alimentant le moteur;

le rangement, dans un bloc de mémoire (102, 103) des valeurs mesurées de la résistance $r_1$ et de la réactance $X_o$, à des adresses correspondant à la pulsation du courant;

la détermination et le rangément, dans un bloc de mémoire (101), de coefficients $a\,(\omega)$ à des adresses correspondant à la pulsation $\omega$ du courant, ces coefficients étant obtenus au moyen de la relation:

$$a\,(\omega) = \frac{R_c - r_1}{X_o - X_c} = \frac{R_c\,(\omega) - r_1}{X_o\,(\omega) - X_c\,(\omega)}$$

la mesure de la résistance R et de la réactance X du moteur en fonctionnement alimenté à la pulsation $\omega$;

la détermination d'une constante

$$K = \frac{R - r_1}{X_o - X};$$

la détermination dans la mémoire (101) à quelle valeur de pulsation $\omega K$ correspond le terme K, tel que $K = a\,(\omega K)$; et

la détermination du glissement par le rapport

$$\frac{\omega K}{\omega} = g.$$

3. Dispositif pour la déterminatioon du glissement d'un moteur asynchrone (1) alimenté par une source polyphasée à pulsation variable (2) sans utilisation d'un détecteur tachymétrique, à partir de mesures de tension et de courant effectuées aux bornes statoriques du moteur, caractérisé en ce qu'il comprend:

des premiers moyens permettant de mesurer la résistance statorique $r_1$ du moteur alimenté à l'arrêt par un courant continu, et de ranger dans une première mémoire (102) le signal numérique représentant la valeur de $r_1$;

des seconds moyens pour déterminer la réactance $X_o$ du moteur chargé à vide et alimenté par un courant de pulsation $\omega$, et pour ranger dans une seconde mémoire (103) à une adresse correspondant à la pulsation $\omega$, le signal représentatif de la réactance $X_o$;

des troisièmes moyens pour déterminer les valeurs $R_c$ et $X_c$ représentatives de la résistance et de la réactance du moteur, rotor bloqué mécaniquement, alimenté par un signal de pulsation $\omega$, pour déterminer, pour chaque valeur de la pulsation $\omega$, un terme $a\,(\omega)$ ayant pour valeur

$$a(\omega) = \frac{R_c - r_1}{X_o - X_c},$$

et pour ranger dans une troisième mémoire (101) la valeur $a(\omega)$ à l'adresse correspondant à la pulsation $\omega$;
des quatrièmes moyens pour mesurer la résistance R et la réactance X du moteur alimenté avec un signal de pulsation $\omega$ et entraînant une charge, pour extraire desdites première, seconde et troisième mémoires les valeurs $X_o$, $r_1$ et $a(\omega)$ correspondantes et pour calculer le glissement g au moyen d'une formule de la forme

$$g = a(\omega) \cdot \frac{X_o - X}{R - r_1}.$$

4. Dispositif selon la revendication 3, caractérisé en ce que les susdits quatrièmes moyens comprennent des moyens permettant de calculer, pour une pulsation $\omega$ de fonctionnement donnée un terme

$$K = \frac{R_o - r_1}{X_o - X}$$

de déterminer à quelle valeur de pulsation $\omega K$ correspond cette valeur K telle que $K = a(\omega K)$ et de déterminer ensuite le glissement par la formule

$$g = \frac{\omega K}{\omega}.$$

5. Dispositif pour la détermination du glissement d'un moteur asynchrone (M) alimenté par une source polyphasée à pulsation variable sans utilisation d'un détecteur tachymétrique, à partir de mesures de tension et de courant effectuées aux bornes statoriques du moteur, caractérisé en ce qu'il comprend:
un circuit (3) délivrant des signaux représentatifs de la tension instantanée et de la tension efficace de ladite source de tension;
un dispositif (4) pour la mesure de la valeur instantanée et de la valeur efficace du courant délivré par ladite source;
un circuit (5—7) permettant de délivrer, à partir desdites mesures de tension et de courant, des signaux numériques représentatifs de la résistance et de la réactance apparente du moteur, vu du stator:
un esemble à microprocesseur (8) recevant sur une entrée (81) les susdits signaux numériques, cet ensemble comprenant des moyens pour la mémorisation de la valeur de la résistance statorique $r_1$ du moteur à l'arrêt alimenté en courant continu, des moyens pour la mémorisation, à des adresses correspondant à la pulsation $\omega$ de la valeur de la réactance apparente $X_o$ du moteur, lorsque celui-ci est à vide et est alimenté par un signal de pulsation $\omega$, et de la valeur de la résistance apparente $R_c$ et de la réactance apparente $X_c$ du moteur, rotor mécaniquement bloqué, et alimenté avec un signal de pulsation $\omega$, et des moyens pour calculer le glissement g à partir des valeurs mesurées de la résistance apparente R et de la réactance apparente X du moteur alimenté avec un signal de pulsation $\omega$ et entraînant une charge, et des valeurs $r_1$, $X_o$, $X_c$, $R_c$ précédemment mémorisées, à l'aide d'une formule de la forme:

$$g = \frac{R_c - r_1}{X_o - X_c} \cdot \frac{X_o - X}{R - r_1}$$

6. Dispositif selon l'une des revendications 3 à 5, caractérisé en ce que le moteur (1) est alimenté par un convertisseur (2) permettant de délivrer des signaux électriques dont les grandeurs électriques (courant, tension, fréquence ou pulsation) sont ajustables selon une séquence appropriée en vue de déterminer les susdites valeurs $r_1$, $R_c$, $X_c$, $X_o$, R et X.

**Patentansprüche**

1. Verfahren zur Bestimmung des Schlupfes eines Asynchronmotors (1) gespeist von einer Mehrphasenquelle (2) mit variabler Schwingung, ohne Verwendung eines Tachodetektors, mittels, an seinen Statorklemmen ausgeführten, Impedanzmessungen, dadurch gekennzeichnet, dass es beinhaltet: die vorherige Bestimmung, ausgehend von Messungen des Statorwiderstandes $r_1$ am stillstehenden Motor und des Blindwiderstandes $X_o$ für die verschiedenen Schwingungen $\omega$ der den Motor versorgenden Quelle am unbelasteten Motor; die vorherige Bestimmung des Widerstandes $R_c$ und des Blindwiderstandes $X_c$ des Motors, bei blockiertem Rotor, für die verschiedenen Schwingungen $\omega$ der den Motor versorgenden Quelle; die Messung des Widerstandes R und des Blindwiderstandes X des Motors in Betrieb, der mit einer

8

Schwingung ω gespeist wird, und die Berechnung des Schlupfes, ausgehend von den Ergebnissen der vorherigen Bestimmungen und der Messung von R und X, unter Verwendung einer Formel der Form

$$g = a\,(\omega)\,\frac{X_o\,(\omega) - X}{R - r_1}$$

$$\text{mit}\quad a\,(\omega) = \frac{R_c\,(\omega) - r_1}{X_o\,(\omega) - X_c\,(\omega)}$$

2. Verfahren zur Bestimmung des Schlupfes eines Asynchronmotors (1), der von einer Mehrphasenquelle mit variabler Schwingung (2) gespeist wird, ohne Verwendung eines Tachodetektors, mittels an seinen Statorklemmen ausgeführten Impedanzmessungen, dadurch gekennzeichnet, dass es beinhaltet:

die vorherige Bestimmung des Statorwiderstandes $r_1$ ausgehend von am stillstehenden Motor ausgeführten Messungen;

die vorherige Bestimmung, am unbelasteten Motor, des Widerstandes $X_o$ für verschiedene Schwingungen ω der den Motor speisenden Quelle;

die vorherige Bestimmung des Widerstandes $R_c$ und des Blindwiderstandes $X_c$ des Motors bei blockiertem Rotor für verschiedene Schwingungen ω der den Motor speisenden Quelle;

die Speicherung in einem Speicherblock (102, 103) der gemessenen Widderstands- $r_1$ und Blindwiderstandswerte $X_o$ an der Stromschwingung ω entsprechenden Speicherplätzen;

die Bestimmung und Speicherung in einem Speicherblock (101) von a (ω) Koeffizienten an der Stromschwingung ω entsprechenden Speicheradressen, wobei man besagten Koeffizienten durch folgende Gleichung erhält:

$$a\,(\omega) = \frac{R_c - r_1}{X_o - X_c} = \frac{R_c\,(\omega) - r_1}{X_o\,(\omega) - X_c\,(\omega)};$$

die Messung des Widerstandes R und des Blindwiderstandes X des laufenden Motors, der mit einer Schwingung ω gespeist wird;

die Bestimmung einer Konstante

$$K = \frac{R - r_1}{X_o - X};$$

die Bestimmung im Speicher (101) welchem Schwingungswert ωK der Begriff K, wie K = a (ωK), entspricht; und

die Bestimmung des Schlupfes, durch die Beziehung

$$\frac{\omega K}{\omega} = g.$$

3. Verfahren zur Bestimmung des Schlupfes eines Asynchronmotors (1), der von einer Mehrphasenquelle mit variabler Schwingung (2) gespeist wird, ohne Verwendung eines Tachodetektors, ausgehend von an den Statorklemmen des Motors ausgeführten Spannungs- und Strommessungen, dadurch gekennzeichnet, dass es beinhaltet:

erste Mittel, die es ermöglichen, den Statorwiderstand $r_1$ des bei Stillstand mit Gleichstrom gespeisten Motors zu messen und das den Wert von $r_1$ darstellende Digitalsignal in einen ersten Speicher (102) einzuweisen;

zweite Mittel, um den Blindwiderstand $X_o$ des unbelastet unter Spannung stehenden und mit einem Strom, der eine Schwingung ω besitzt gespeisten Motors zu bestimmen und um das den Blindwiderstand $X_o$ darstellende Signal in einen zweiten Speicher (103) an eine Adresse einzuweisen, welche der Schwingung ω entspricht;

dritte Mittel, um die dem Widerstand und den Blindwiderstand des Motors darstellenden Werte $R_c$ und $X_c$ bei mechanisch blockiertem Rotor zu bestimmen, wobei der Motor von einem Signal mit der Schwingung ω gespeist wird, um für jeden Wert der Schwingung ω einen Begriff a (ω) zu bestimmen, dessen Wert

$$a\,(\omega) = \frac{R_c - r_1}{X_o - X_c}$$

ist und um den Wert a (ω) in einen dritten Speicher (101) an die der Schwingung ω entsprechende Adresse einzuweisen;

vierte Mittel, um den Widerstand R und den Blindwiderstand X des Motors zu messen, der mit einem Signal mit einer Schwingung ω gespeist wird und eine Last antreibt, um aus besagten ersten, zweiten und dritten Speichern die entsprechenden Werte $X_o$, $r_1$ und a (ω) zu entnehmen und den Schlupf g mittels der Formel der Form

$$g = a\,(\omega) \cdot \frac{X_o - X}{R - r_1}$$

zu berechnen.

4. Vorrichtung nach Anspruch 3, dadurch gekennzeichnet, dass die obengenannten vierten Mittel Mittel enthalten, um, für eine gegebene Betriebsschwingung ω einen Begriff.

$$K = \frac{R_o - r_1}{X_o - X}$$

zu berechnen, um zu bestimmen, welchem Schwingungswert ωK dieser Wert K, bei dem K = a (ωK) ist, entspricht und dann den Schlupf durch die Formel

$$g = \frac{\omega k}{\omega}$$

zu bestimmen.

5. Vorrichtung zur Bestimmung des Schlupfes eines Asynchronmotors (M), der durch eine Mehrphasenquelle mit variabler Schwingung gespeist wird, ohne Verwendung eines Tachodetektors, ausgehend von an den Statorklemmen des Motors ausgeführten Spannungs- und Strommessungen, dadurch gekennzeichnet, dass sie beinhaltet:

einen Schaltkreis (3), der Signale aussendet, die repräsentativ sind für die momentane und Effektivspannung der besagten Spannungsquelle;

eine Vorrichtung (4), um den momentanen und den Effektivwert des von besagter Quelle gelieferten Stroms zu messen;

einen Schaltkreis (5—7), welcher es ermöglicht, von besagten Spannung- und Strommessungen ausgehend, Digitalsignale abzugeben, welche repräsentativ sind für den Widerstand und den scheinbaren Blindwiderstand des Motors, vom Stator aus gesehen;

eine Mikroprozessoreinheit (8), welche an einem Eingang (81) die obengenannten Digitalsignale empfängt, wobei besagte Einheit Mittel enthält, zur Speicherung des Statorwiderstandswertes $r_1$ des stillstehenden und mit Gleichstrom gespeisten Motors, Mittel zur Speicherung, an der Schwingung ω entsprechenden Adressen, des Wertes des scheinbaren Blindwiderstandes $X_o$ des Motors, wenn dieser umbelastet ist und mit einem Signal mit einer Schwingung ω gespeist wird und des Wertes des scheinbaren Widerstandes $R_c$ und des scheinbaren Blindwiderstandes $X_c$ des Motors bei mechanisch blockiertem Rotor und mit einem Signal mit der Schwingung ω gespeist, und Mittel, um den Schlupf g zu berechnen, ausgehend von den gemessenen Werten des scheinbaren Widerstandes R und des scheinbaren Blindwiderstandes X des Motors, der mit einem Signal mit der Schwingung ω gespeist wird und eine Last antreibt und von den vorher gespeicherten Werten $r_1$, $X_o$, $X_c$, $R_c$, mittels einer Formel der Form

$$g = \frac{R_c - r_1}{X_o - X_c} \cdot \frac{X_o - X}{R - r_1}$$

6. Vorrichtung nach einem der Ansprüche 3 bis 5, dadurch gekennzeichnet, dass der Motor (1) von einem Umsetzer (2) gespeist wird, der es ermöglicht, elektrische Signale abzugeben, deren elektrische Grössen (Strom, Spannung, Frequenz oder Schwingung) gemäss einer angemessenen Folge einstellbar sind, um die obengenannten Werte $r_1$, $R_c$, $X_c$, $X_o$, R und X zu bestimmen.

**Claims**

1. A method for determining the slip of an asynchronous motor (1) fed from a multiphase source having a variable pulsation (2) without using a tachometric detector, by means of impedance measurements effected at its stator terminals, characterized in that it comprises the preliminary determination, starting from measurements effected on the stopped motor, of the stator resistance $r_1$ and, on the off-load motor, of the reactance $X_o$ for the different pulsations ω of the source which feeds the motor; the preliminary determination of the resistance $R_c$ and the reactance $X_c$ of the motor, with locked rotor, for the different pulsations ω of the source feeding the motor; measuring of the resistance R and of the reactance X of the motor in operation fed at a pulsation $\omega$, and calculating the slip from the results of the preliminary determinations and the measurement of R and X, using a formula of the form:

$$G = a(\omega) \frac{X_o(\omega) - X}{R - r_1}$$

$$\text{with:} \quad a(\omega) = \frac{R_c(\omega) - r_1}{X_o(\omega) - X_c(\omega)}$$

2. A method for determining the slip of an asynchronous motor (1) fed from a multiphase source (2) having a variable pulsation without using a tachometric detector, by means of impedance measurements effected at its stator terminals, characterized in that it comprises:

the preliminary determination of the stator resistance $r_1$, starting from measurements effected on the stopped motor;

the preliminary determination, on the off-load motor, of the resistance $X_o$ for different pulsations $\omega$ of the source feeding the motor;

the preliminary determination of the resistance $R_c$ and the reactance $X_c$ of the motor, with locked rotor, for different pulsations $\omega$ of the source feeding the motor;

storage in a memory block (102, 103) of the measured values of the resistance $r_1$ and of the reactance $X_o$ at addresses corresponding to the current pulsation;

the determination and storage in a memory block (101) of a ($\omega$) coefficients at addresses corresponding to the current pulsation $\omega$, these coefficients being obtained by the relation:

$$a(\omega) = \frac{R_c - r_1}{X_o - X_c} = \frac{R_c(\omega) - r_1}{X_o(\omega) - X_c(\omega)}$$

measurement of the resistance R and the reactance X of the motor in operation fed at a pulsation $\omega$: the determination of a constant

$$K = \frac{R - r_1}{X_o - X}$$

the determination, in memory (101), to which pulsation value $\omega K$ corresponds to term K, such as $K = a(\omega K)$; and

The determination of the slip by the relation

$$\frac{\omega K}{\omega} = g.$$

3. Device for determining the slip of an asynchronous motor (1) fed by a multiphase source with variable pulsation (2) without using a tachometric detector, starting from voltage and current measurements effected at the stator terminals of the motor, characterized in that it comprises:

first means for measuring the stator resistance $r_1$ of the motor fed, in its stopped condition, with a D—C current and storing, in a first memory (102), the digital signal representing the value of $r_1$;

second means for determining the reactance $X_o$ of the charged off-load motor fed with a current having a pulsation $\omega$ and for storing, in a second memory (103), at an address corresponding to pulsation $\omega$, the signal representative of the reactance $X_o$;

third means for determining the values $R_c$ and $X_c$ representative of the resistance and of the reactance of the motor, with mechanically locked rotor, fed by a signal having a pulsation $\omega$, for determining, for each value of the pulsation $\omega$, a term a ($\omega$) whose value is

$$a(\omega) = \frac{R_c - r_1}{X_o - X_c}$$

and for storing, in a third memory (101), value a ($\omega$) at an address corresponding to pulsation $\omega$;

fourth means for measuring the resistance R and the reactance X of the motor fed with a signal having a pulsation $\omega$ and driving a load, for taking from said first, second and third memories the corresponding values $X_o$, $r_1$ and a ($\omega$) and for calculating the slip g by means of a formula of the form:

$$g \doteq a\,(\omega) \cdot \frac{X_o - X}{R - r_1}$$

4. Device according to claim 3, characterized in that said fourth means comprise means for calculating, for a given operating pulsation $\omega$, a term

$$K = \frac{R_o - r_1}{X_o - X}$$

for determining to which pulsation value $\omega K$ corresponds this value K such as $K = a\,(\omega K)$ and for then determining the slip by the formula

$$g = \frac{\omega K}{\omega}$$

5. Device for determining the slip of an asynchronous motor (M) fed from a multiphase source having a variable pulsation, without using a tachometric detector, starting from voltage and current measurements effected at the stator terminals of the motor, characterized in that it comprises:

a circuit (3) delivering signals representative of the instantaneous and the effective voltage of said voltage source;

a device (4) for measuring the instantaneous and the effective value of the current delivered by said source;

a circuit (5—7) allowing delivery, starting from said voltage and current measurements, of digital signals representative of the resistance and the apparent reactance of the motor as seen from the stator;

a microprocessor (8) assembly receiving at one input (81) said digital signals, this assembly comprising means for storing the value of the stator resistance $r_1$ of the stopped motor fed with D—C current, means for storing, at addresses corresponding to pulsation $\omega$, of the value of the apparent reactance $X_o$ of the motor when it is off-load and fed with a signal having a pulsation $\omega$, and of the value of the apparent resistance $R_c$ and of the apparent reactance $X_c$ of the motor mechanically locked rotor and fed with a signal having a pulsation $\omega$, and means for calculating the slip g from the measured values of the apparent resistance R and the apparent reactance X of the motor fed with a signal having a pulsation $\omega$ and driving a charge, and values $r_1$, $X_o$, $X_c$ and $R_c$ previously stored, by means of a formula of the form:

$$g = \frac{R_c - r_1}{X_o - X_c} \cdot \frac{X_o - X}{R - r_1}$$

6. Device according to one of claims 3 to 5, characterized in that the motor (1) is fed by a converter (2) allowing delivery of electric signals whose electric scale (current, voltage, frequency or pulsation) is adjustable according to an appropriated sequence with a view of determining the above-mentioned values $r_1$, $R_c$, $X_c$, $X_o$, R and X.

FIG.1

0 101 773

FIG 2

0 101 773

2

FIG. 3

FIG. 4